Europäisches Patentamt

European Patent Office

Office européen des brevets

(11) Veröffentlichungsnummer: **0 354 269 B1**

# (12) EUROPÄISCHE PATENTSCHRIFT

(45) Veröffentlichungstag der Patentschrift: **31.03.93**

(51) Int. Cl.5: **G01R 27/20**

(21) Anmeldenummer: **88113342.5**

(22) Anmeldetag: **17.08.88**

(54) **Schaltungsanordnung zur Überwachung des Übergangswiderstandes bei einem als Stellungsgeber dienenden Potentiometer.**

(30) Priorität: **09.08.88 DE 3826937**

(43) Veröffentlichungstag der Anmeldung:
**14.02.90 Patentblatt 90/07**

(45) Bekanntmachung des Hinweises auf die
Patenterteilung:
**31.03.93 Patentblatt 93/13**

(84) Benannte Vertragsstaaten:
**DE ES FR GB IT SE**

(56) Entgegenhaltungen:
**DE-A- 3 522 775**

**BRITISH TELECOMMUNICATIONS ENGINEE-RING, Band 3, Nr. 2, Juli 1984, Seiten 132-136, London, GB; B. WILTSHIRE et al.: "The development of a computer-aided contact resistance measurement system"**

(73) Patentinhaber: **VDO Adolf Schindling AG
Gräfstrasse 103
W-6000 Frankfurt/Main 90(DE)**

(72) Erfinder: **Rossberg, Rainer
Schlesienstrasse 5
W-6231 Schwalbach/Ts(DE)**
Erfinder: **Weiss, Werner
Parkstrasse 15
W-6233 Kelkheim(DE)**

(74) Vertreter: **Klein, Thomas, Dipl.-Ing. (FH)
Sodener Strasse 9 Postfach 6140
W-6231 Schwalbach a. Ts. (DE)**

**Beschreibung**

Die Erfindung betrifft ein Steuergerät zur Überwachung eines als Stellungsgeber dienenden und parallel zu einem Abgleichwiderstand liegenden Potentiometers einer Steuer- und/oder Regeleinrichtung, insbesondere für Kraftfahrzeuge, enthaltend einen Mikroprozessor, eine Referenz-Spannungsquelle, einen Operationsverstärker, einen Transistor und einen Widerstand. Ein derartiges Steuergerät ist aus der DE-A-3 522 775 bekannt.

Die Leistung einer Brennkraftmaschine wird im allgemeinen entsprechend dem Willen des Fahrers durch eine Stelleinrichtung, insbesondere durch ein Fahrpedal, beeinflußt. Zur Übertragung der Stellung des Fahrpedals sind neben mechanischen Verbindungen elektronische Steuerungssysteme unter der Bezeichnung E-Gas-Anlagen bekanntgeworden. Insbesondere bei Nutzfahrzeugen mit Unterflur- oder Heckmotoren oder Schubgelenkbussen können die notwendigen Pedalkräfte bei mechanischer Übertragung durch Gestänge oder Bowdenzüge nur durch sorgfältige Verlegung niedrig und unabhängig von Karosseriebewegungen gehalten werden.

Bei den bekannten elektronischen Einrichtungen zum Steuern der Leistung der Brennkraftmaschine eines Kraftfahrzeugs dient ein mit dem Gaspedal verbundener erster Stellungsgeber als Sollwertgeber, während ein zweiter Stellungsgeber als Istwertgeber mit der Drosselklappe oder dem Verstellhebel der Einspritzpumpe mechanisch gekuppelt ist. Eine Regeleinrichtung vergleicht elektrische Signale, welche den Sollwert und den Istwert darstellen, und verstellt mittels eines Servomotors die Drosselklappe oder den Verstellhebel der Einspritzpumpe mit dem damit gekuppelten Stellungsgeber im Sinne einer Angleichung des Istwertes an den Sollwert.

In diesen bekannten E-Gas-Anlagen, die mit elektrischen Analogsignalen arbeiten, werden als Stellungsgeber im allgemeinen Potentiometer verwendet. Aus Sicherheitsgründen wird sowohl für den Sollwertgeber als auch für den Istwertgeber eine genaue Zuordnung von Schleiferstellung und Spannungswert innerhalb enger Toleranzen gefordert, die auch nach längerer Betriebsdauer erhalten bleiben soll. Infolge der Einwirkung der Anmosphäre, von Kraftstoff, Öl oder Kondenswasser können sich jedoch Übergangswiderstände zwischen der Widerstandsbahn und dem darauf gleitenden Schleifer bilden, welche die ursprüngliche Zuordnung von Schleiferstellung und Spannungswert verändern. Dieses kann zu unerwünschten und auch gefährlichen Fahrzuständen führen. Man hat daher schon eine Vorrichtung zur Bestimmung des Übergangswiderstandes am Schleifer eines Potentiometers vorgeschlagen (DE-A-35 22 775).

Der Erfindung liegt die Aufgabe zugrunde, eine derartige Vorrichtung ohne großen Kostenaufwand weiter zu verbessern, um Veränderungen am Potentiometer umfassender überwachen zu können.

Diese Aufgabe wird bei einem Steuerungsgerät der eingangs genannten Art dadurch gelöst, daß im Steuergerät

- zwischen einem Anschluß des Steuergeräts für die Versorgung des Potentiometers mit einer vom Operationsverstärker konstant gehaltenen Spannung und dem Operationsverstärker ein Strommeßwiderstand angeordnet ist, dessen Spannungsabfall als repräsentatives Signal für den über die Parallelschaltung aus Potentiometer und Abgleichwiderstand fließenden Strom über einen Eingang dem Mikroprozessor zuführbar ist und

- zwischen einem Anschluß des Steuergeräts für das abgegriffene Signal des Potentiometers und einem Anschluß des Steuergeräts für die Masseleitung eine Reihenschaltung, bestehend aus dem Widerstand und der Kollektor-Emitterstrecke des Transistors angeordnet ist, letzterer über einen Ausgang des Mikroprozessors und einen weiteren Widerstand ansteuerbar und das Nutzsignal über einen Eingang dem Mikroprozessor zuführbar ist.

Das erfindungsgemäße Steuergerät hat den Vorteil, daß eine Erhöhung des Übergangswiderstandes bereits erfaßbar ist, wenn noch kein sicherheitskritischer Wert erreicht ist. Außerdem läßt sich das erfindungsgemäße Steuergerät mit einfachen Mitteln herstellen.

Dabei ist vorteilhaft, daß das erfindungsgemäße Steuergerät auch unter betriebsmäßigen Bedingungen benutzt werden kann. So ist es beispielsweise möglich, jeweils vor Fahrtantritt automatisch den Übergangswiderstand zu überprüfen. Dieses kann jedoch auch periodisch in den Pausen eines Betriebsprogramms erfolgen, welches die Nachführregelung bewerkstelligt, oder aber während des Betriebsprogramms durch kurzzeitiges Prüfen, wenn die nachfolgend beschriebene Beeinflussung der gemessenen Schleiferspannung von einer Dauer ist, die klein gegenüber den Zeitkonstanten von Stelleinrichtung und Brennkraftmaschine ist.

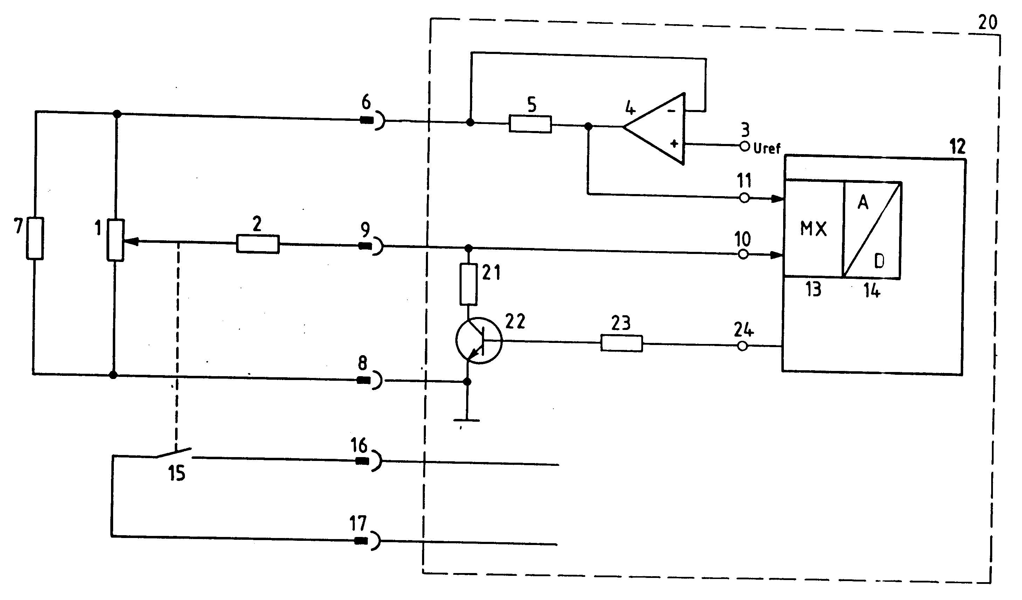

Die Erfindung läßt zahlreiche Ausführungsformen zu. Eine davon ist schematisch in der Zeichnung dargestellt und nachfolgend beschrieben.

Das Potentiometer 1 stellt einen Ist- oder Sollwertgeber dar und ist dazu beispielsweise mit einer Drosselklappe oder einem Fahrpedal verbunden, was in der Zeichnung jedoch nicht dargestellt ist. Dem Potentiometer 1 ist ein Abgleichwiderstand 7 parallelgeschaltet. In mechanischer Verbindung mit dem Schleifer des Potentiometers 1 steht ein Schalter 15, der an sich in bekannter Weise als Sicherheitskontakt dient. Sowohl das Potentiometer als auch der Schalter 15 sind mit Anschlüssen 6, 9, 8, 16, 17 eines digitalen Steuergerätes 20 verbunden.

Das digitale Steuergerät 20 besteht im wesentlichen aus einem Mikrocomputer 12, von welchem der Übersichtlichkeit halber nur ein Multiplexer 13 und ein Analog/Digital-Wandler 14 dargestellt ist. Den Eingängen 10, 11 zugeführte Gleichspannungen werden in digitale Signale umgewandelt. Innerhalb des Steuergerätes 20 ist ferner eine Schaltung zur Spannungsversorgung des Potentiometers 1 vorgesehen, die aus einer nicht dargestellten Referenzspannungsquelle besteht, deren Spannung Uref über den Anschluß 3 einem Operationsverstärker 4 zugeführt wird. Zwischen dem Ausgang des Operationsverstärkers 4 und dem Anschluß 6 bzw. dem Potentiometer 1 ist ein Strommeßwiderstand 5 vorgesehen.

Da der von dem Operationsverstärker gebildete Regelkreis die Spannung am Anschluß 6 konstant hält, ist die Spannung am Ausgang des Operationsverstärkers ein Maß für den Strom durch das Potentiometer 1 und den Abgleichwiderstand 7. Diese Spannung wird dem Eingang 11 des Mikrocomputers 12 zugeführt. Durch Vergleich mit für diese Spannung vorgesehenen Grenzwerten kann somit festgestellt werden, ob zu wenig oder zu viel Strom durch das Potentiometer 1 fließt, das heißt, ob eine Unterbrechung oder ein Kurzschluß vorliegt oder ein Kontaktübergangswiderstand an den Klemmen 6 oder 8 oder ein fehlerhafter Parallelwiderstand zu Widerstand 7.

Zur Veranschaulichung der Überwachung des Übergangswiderstandes des Potentiometers 1 ist der Übergangswiderstand in der Zeichnung als separater Widerstand 2 dargestellt. Entsprechend der Winkelstellung des Potentiometers 1 nimmt die Spannung am Anschluß 9 einen Wert zwischen Massepotential (Anschluß 8) und der Versorgungsspannung Uref am Anschluß 6 an. Über den Eingang 10 wird diese Spannung dem Mikrocomputer 12 zugeführt, der aus dieser Spannung die Stellung des Potentiometers 1 berechnet und zur Regelung bzw. Steuerung verwendet.

Zur Überwachung des Übergangswiderstandes 2 ist zwischen den Anschlüssen 9 und 8 des Steuergerätes 20 eine Reihenschaltung aus einem Widerstand 21 und einem Transistor 22 vorgesehen. Der Transistor 22 kann von einem Signal in den leitenden oder nichtleitenden Zustand geschaltet werden, das von einem Ausgang 24 des Mikrocomputers 12 über einen Widerstand 23 der Basis des Transistors 22 zuführbar ist. Je nach Ausführung der Erfindung erzeugt der Mikrocomputer 12 beim Einschalten an seinem Ausgang 24 ein kurzzeitiges positives Signal oder in vorgegebenen Zeitabständen. Dadurch wird der Schleifer des Potentiometers kurzzeitig belastet, so daß die Spannung am Anschluß 9 sinkt.

Der Transistor 22 als Schaltelement kann auch durch einen Feldeffekttransistor ersetzt werden. Die Funktion der Gesamtschaltung wird dadurch nicht wesentlich beeinflußt.

Der Widerstand 21 ist derart bemessen, daß einerseits das Potentiometer während der Belastung durch den Widerstand 21 nicht überlastet wird und daß andererseits eine deutlich meßbare Spannungsverminderung am Anschluß 9 entsteht, wenn der Übergangswiderstand einen Wert erreicht hat, bei dem eine Anzeige oder andere geeignete Maßnahmen vorgesehen sind.

Der Innenwiderstand Ri einer von einem Potentiometer gebildeten Spannungsquelle als Funktion des Stellwinkels a des Potentiometers folgt der Gleichung:

```
Ri(a) = (Rges*a*Rges(1-a)) / (Rges*a + Rges(1-a))
      = Rges * a * (1 - a).
```

Dabei ist Rges der Widerstand zwischen den beiden Endkontakten der Potentiometerbahn. Da der Eingangswiderstand des Mikrocomputers an seinem Eingang 10 wesentlich größer als der Innenwiderstand Ri ist, ergibt sich bei einer ersten Messung eine Spannung am Anschluß 9 von U1 = Uref * a. Bei einer zweiten Messung, bei welcher der Transistor 22 leitend ist, beträgt die Spannung U2 = Uref * a * R21 / (R21 + Ri (a) + Rüs). Dabei ist R21 der Widerstandswert des Widerstandes 21 und Rüs der Übergangswiderstand des Schleifers. Mit Hilfe eines entsprechenden Programms ist es im Mikrocomputer möglich, durch beide Messungen den Widerstand Rüs zu ermitteln, mit einem vorgegebenen Wert zu vergleichen und entsprechende Maßnahmen zu ergreifen, beispielsweise eine Warnlampe aufleuchten zu lassen.

Zusammen mit der Überwachung des Stroms durch das Potentiometer mit Hilfe des Strommeßwiderstandes 5 werden somit die wichtigsten Fehlerquellen im Bereich des Potentiometers überwacht.

3

# EP 0 354 269 B1

## Patentansprüche

1. Steuergerät (20) zur Überwachung eines als Stellungsgeber dienenden und parallel zu einem Abgleichwiderstand (7) liegenden Potentiometers (1) einer Steuer- und/oder Regeleinrichtung, insbesondere für Kraftfahrzeuge, enthaltend einen Mikroprozessor (12), eine Referenz-Spannungsquelle (3), einen Operationsverstärker (4), einen Transistor (22) und einen Widerstand (21), dadurch gekennzeichnet, daß im Steuergerät (20)

   - zwischen einem Anschluß (6) des Steuergeräts (20) für die Versorgung des Potentiometers (1) mit einer vom Operationsverstärker (4) konstant gehaltenen Spannung und dem Operationsverstärker (4) ein Strommeßwiderstand (5) angeordnet ist, dessen Spannungsabfall als repräsentatives Signal für den über die Parallelschaltung aus Potentiometer (1) und Abgleichwiderstand (7) fließenden Strom über einen Eingang (11) dem Mikroprozessor (12) zuführbar ist und
   - zwischen einem Anschluß (9) des Steuergeräts (20) für das abegriffene Signal des Potentiometers (1) und einem Anschluß (8) des Steuergeräts (20) für die Masseleitung eine Reihenschaltung, bestehend aus dem Widerstand (21) und der Kollektor-Emitterstrecke des Transistors (22) angeordnet ist, letzterer über einen Ausgang (24) des Mikroprozessors (12) und einen weiteren Widerstand (23) ansteuerbar und das Nutzsignal über einen Eingang (10) dem Mikroprozessor (12) zuführbar ist.

2. Steuergerät nach Anspruch 1, dadurch gekennzeichnet, daß im Mikroprozessor (12) Grenzwerte für den Spannungsabfall am Strommeßwiderstand (5) abgelegt sind.

3. Steuergerät nach Anspruch 1 oder 2, dadurch gekennzeichnet, daß zum Vergleich des Übergangswiderstands des Potentiometers (1) mit Grenzwerten im Mikroprozessor (12) diese Grenzwerte für den Spannungsunterschied des Nutzsignals mit und ohne Zuschaltung des Widerstands (21) abgelegt worden sind.

## Claims

1. A controller (20) for monitoring a potentiometer (1) of a control and/or regulating device, particularly for motor vehicles, wherein the potentiometer serves as a position indicator and is connected in parallel to a balancing resistor (7), and wherein the controller contains a microprocessor (12) a reference voltage source (3), an operational amplifier (4), a transistor (22) and a resistor (21), characterised in that in the controller (20)

   - a current measuring resistor (5) is disposed between the operational amplifier (4) and a connection (6) of the controller (20) for supplying the potentiometer (1) with a voltage which is maintained constant by the operational amplifier (4), wherein the voltage drop across the current measuring resistor can be fed via an input (11) to the microprocessor (12) as a representative signal for the current flowing across the parallel connection comprising the potentiometer (1) and the balancing resistor (7), and
   - a series connection comprising the resistor (21) and the collector-emitter section of the transistor (22) is disposed between a connection (9) of the controller (20) for the measured signal of the potentiometer (1) and a connection (8) of the controller (20) for the earth lead, wherein the transistor can be triggered via an output (24) of the microprocessor (12) and a further resistor (23) and wherein the useful signal can be fed to the microprocessor (12) via an input (10).

2. A controller according to Claim 1, characterised in that limiting values for the voltage drop at the current measuring resistor (5) are stored in the microprocessor (12).

3. A controller according to Claim 1 or 2, characterised in that these limiting values for the difference in voltage of the useful signal with and without the resistor (21) connected have been stored in the microprocessor (12) for comparing the contact resistance of the potentiometer (1) with limiting values.

## Revendications

1. Circuit de contrôle (20) destiné à surveiller la résistance de contact d'un potentiomètre (1) servant de capteur de position et monté en parallèle avec une résistance de tarage (7) dans un dispositif de commande et/ou de réglage, notamment pour automobiles, ce circuit comprenant un microordinateur

4

(12), une source (3) de tension de référence, un amplificateur opérationnel (4), un transistor (22) et une résistance (21) et étant caractérisé en ce que

- entre une borne (6) dudit circuit (20), destinée à délivrer au potentiomètre (1) une tension que l'amplificateur opérationnel (4) rend constante, et cet amplificateur (4), il est disposé une résistance (5) de mesure du courant, dont la chute de tension, constituant un signal représentatif du courant qui passe dans ce potentiomètre (1) et dans la résistance de tarage (7) montée en parallèle avec lui, peut être délivrée au microordinateur (12) par une entrée (11), et
- entre une borne (9) du circuit de contrôle (20) recevant le signal prélevé sur le potentiomètre (1) et une borne (8) de ce circuit (20) reliée au conducteur de masse, il est disposé en série la résistance (21) et la liaison collecteur-émetteur du transistor (22) ; ce dernier peut être déclenché par l'entremise d'une sortie (24) du microordinateur (12) et d'une autre résistance (23), et le signal utile peut être délivré à ce microordinateur (12) par une entrée (10).

2. Circuit de contrôle selon la revendication 1, caractérisé en ce que des valeurs limites de la chute de tension dans la résistance (5) de mesure du courant sont enregistrées dans le microordinateur.

3. Circuit de contrôle selon la revendication 1 ou 2, caractérisé en ce que, pour comparer la résistance de contact du potentiomètre (1) avec les valeurs-limites, ces valeurs limites de la différence de tension du signal utile ont été enregistrées dans le microordinateur (12) avec et sans interposition de la résistance (21).

EP 0 354 269 B1